# DEMANDE DE BREVET EUROPEEN

(11) **EP 2 145 701 A1**
(43) Date de publication de la demande: **20.01.2010**
(21) Numéro de dépôt: 08160512.3
(22) Date de dépôt: 16.07.2008
(51) Int. Cl.: B08B 7/00

(54) **Procédé et installation pour la préparation de surface par décharge à barrière diélectrique**

(71) Demandeur: AGC Flat Glass Europe SA, 1170 Bruxelles (BE)
(72) Inventeur: La désignation de l'inventeur n'a pas encore été déposée
(74) Mandataire: Vandeberg, Marie-Paule L.G.

(57) **Abrégé**

Un procédé pour la préparation de surface d'un substrat (2) qui comprend notamment l'introduction ou le défilement d'un substrat (2) dans une chambre de réaction (6, 106) dans laquelle sont placées au moins deux électrodes (1, 10, 110). Au moins une barrière diélectrique (14,114) est placée entre ces au moins deux électrodes (1, 10, 110). Une tension électrique à haute fréquence de valeur telle qu'elle entraîne la génération d'un plasma (12, 112) est engendrée entre les deux électrodes (1, 10, 110). On introduit dans la chambre de réaction (6, 106) au moins un type de molécules (8, 108) telles qu'au contact du plasma, elles engendrent des espèces actives aptes à réagir avec la surface du substrat. On met en service une inductance ajustable (L) disposée en parallèle avec l'inductance de l'installation engendrant la tension électrique, de façon à réduire le déphasage entre la tension et le courant engendré et augmenter le temps de passage du courant dans le plasma (12, 112).

## Description

### Domaine de l'invention

L'invention concerne les procédés et installations pour la préparation de surface de substrats préalablement à leur traitement.

### Préambule

Il existe différentes opérations pour améliorer la qualité des matériaux bruts tels que le verre, l'acier, le plastique, etc.... Parmi ces opérations, on retrouve le traitement et la préparation de surface. On parle de traitement de surface lors de dépôt de couche sur un substrat, alors que la préparation de surface consiste, comme son nom l'indique, soit à préparer la surface d'un substrat pour la rendre apte à recevoir un dépôt, soit à modifier ses propriétés de surface par la création de nouvelles liaisons (activation de surface). L'invention se rapporte à un procédé de préparation de surface par décharge à barrière diélectrique (DBD) permettant de nettoyer, de dégraisser, d'aviver, de décaper ou encore d'activer la surface, afin de modifier et/ou d'améliorer les propriétés de surface du dit substrat. En particulier, l'invention vise à préparer la surface dans le but notamment de nettoyer le substrat en éliminant les couches ou les contaminants organiques, d'aviver la surface en éliminant les couches ou les contaminants inorganiques ou encore d'activer la surface par la création de nouvelles liaisons sur la surface du substrat.

L'invention se rapporte aussi à une installation permettant d'appliquer le procédé DBD (pour « Décharge à Barrière Diélectrique ») en question, notamment en continu.

### État de la technique

Les principales opérations pour préparer une surface visent à éliminer, dans un premier temps, les résidus organiques (par exemple des huiles) et toutes les salissures qu'ils retiennent. Cette opération porte le nom générique de nettoyage ou dégraissage. Dans un deuxième temps, la surface subit un traitement de réduction des oxydes lorsqu'ils sont présents. Cette opération porte le nom générique de décapage ou avivage. Ces opérations sont des opérations clés dans un processus industriel complet, car si elles sont mal maîtrisées des problèmes peuvent survenir (manque d'adhérence des dépôts réalisés après la préparation de surface, faible tenue à la corrosion, problème d'aspect) et la qualité du produit fini ne peut pas être garantie.

On distingue principalement deux techniques de préparation de surface : par voie humide, notamment électrochimique, avec l'utilisation de solutions basique ou acide et par voie sèche, notamment par l'utilisation de décharge plasma.

La préparation de surface est réalisée aujourd'hui essentiellement par voie "humide". Afin d'augmenter l'efficacité du procédé, la préparation de surface est souvent combinée, dans le cas de substrat conducteur électrique, avec une action électrolytique.

Dans le cas notamment de la métallurgie, la première opération d'une préparation de surface par voie humide est un nettoyage grossier par l'utilisation de solvant. Cette opération contribue à éliminer la majeure partie des polluants organiques. La seconde opération est un dégraissage chimique (bain). Ces dégraissages sont tous deux destinés à détruire le résidu huileux de faible épaisseur. Ces opérations éliminent 95 à 98 % de la couche organique. Après cette préparation de surface, la contamination résiduelle est de l'ordre de 1 mg/m².

Un bain de dégraissage est en général composé d'une solution à base de NaOH et de produits additionnels. La soude apporte à la solution une action saponifiante.

Dans le cas de substrat conducteur, un dégraissage électrolytique est généralement employé comme finition. La solution est utilisée comme électrolyte et le matériau à traiter occupe alternativement la position d'anode et/ou de cathode. Un bon compromis réside dans l'utilisation de polarisations de bande alternées du type cathodique-anodique-anodique-cathodique. La composition des bains électrolytiques est proche des solutions dégraissantes et les conditions opératoires sont différentes selon la nature du bain. Les dégraissages chimique et électrolytique permettent d'éliminer l'interface organique chimiquement liée au substrat en lui conférant une mouillabilité requise pour un traitement de surface ultérieur. Après cette préparation de surface, la contamination résiduelle est de l'ordre de 0,1 mg/m².

Toujours dans le domaine de la métallurgie, après un dégraissage électrolytique, il est souvent nécessaire d'attaquer la surface afin d'éliminer les oxydes éventuellement présents. Etant donné le caractère basique ou amphotère des oxydes, on utilise une solution de décapage acide (sulfurique H2SO4 ou chlorhydrique HCl). Dans le cas de substrat conducteur un décapage électrolytique peut être également ajouté. Comme pour le dégraissage, des polarités alternées sont utilisées pour le décapage. En général, elles sont du type cathodique-anodique-anodique-cathodique, bien que d'autres combinaisons soient possibles.

Toutefois, les normes relatives à l'environnement et à la sécurité étant de plus en plus restrictives et sévères, ces procédés deviennent fort coûteux car on oblige les industries à limiter les quantités utilisées et à recycler les eaux usées avant rejet.

Une possibilité de solution aux problèmes liés à l'environnement consisterait à remplacer la préparation de surface obtenue par voie "humide" par l'emploi d'une technologie plasma sous vide ou à haute pression. Cette technique présente les avantages d'un procédé "sec" respectant l'environnement. Dans le domaine des préparations de surface (nettoyage, avivage et activation de surface), les plasmas fréquemment utilisés sont des plasmas où la température du gaz est proche de la température ambiante (plasma hors équilibre). Ils permettent une préparation de surface des matériaux sans modifier leurs propriétés mécaniques.

Les espèces actives du plasma ainsi créées (électrons, ions, métastables, radicaux...) possèdent typiquement des énergies de plusieurs eV et peuvent ainsi provoquer la dissociation ou l'activation des liaisons chimiques de surface.

Le tableau ci-après résume les principales différences entre le procédé chimique classique et le procédé plasma.

| **Procédé chimique classique** | **Procédé plasma** |
|---|---|
| Procédé très sensible au temps et à la concentration chimique. | Contrôles des paramètres aisés (nature du gaz, pression, temps de traitement, énergie transférée,...). |
| La fiabilité du procédé nécessite l'élimination ou la neutralisation des résidus, ce qui peut nécessiter de multiples étapes. | Sans effluents. |
| Retraitement coûteux de grandes quantités de déchets liquides. | Les déchets produits sont généralement gazeux et peuvent normalement être rejetés vers l'atmosphère. |
| Beaucoup d'acides et de solvants utilisés par ce procédé sont dangereux. | Les gaz utilisés ne sont en général pas toxiques. |
| Connu, fiable, éprouvé. | Nouveau. |

Pour maintenir le plasma hors équilibre (plasma froid), il est souvent nécessaire de travailler à pression réduite. La plupart des techniques plasmas connues utilisent donc des plasmas à basse pression. Beaucoup de travaux ont donc été réalisés dans le domaine des plasmas à pression réduite. Cependant, cette technique présente quelques désavantages. En effet, avec ce type de procédé il n'est pas possible de traiter des matériaux qui ont des pressions de vapeur élevées. Un autre désavantage majeur des procédés basse pression (ex : etching sous vide) est, outre leur coût en terme d'investissement au niveau du pompage et des équipements, la relativement faible efficacité du procédé. Ceci a motivé la recherche de nouveaux procédés aboutissant à l'obtention de plasmas froids à haute pression ou à pression atmosphérique.

Différents procédés plasmas sont utilisés à l'heure actuelle pour préparer les surfaces sur des substrats divers. Ils se différencient notamment par la façon dont l'énergie est engendrée pour la production d'espèces actives nécessaire à la préparation de surface. Parmi ces différents procédés, la DBD (Décharge à Barrière Diélectrique) combine les avantages des plasmas hors d'équilibre sans les inconvénients posés par le problème du vide. De plus, elle semble prometteuse pour la préparation de grandes surfaces.

Les substrats concernés peuvent être de divers types : verre, acier, céramique, etc. Le procédé DBD générant des plasmas froids (hors équilibre), il peut être également appliqué sur différents substrats même thermosensibles comme les polymères organiques, thermoplastiques...

Notre choix s'est porté sur l'utilisation d'une décharge à barrière diélectrique (DBD) car cette dernière a l'avantage, par rapport à d'autres procédés plasmas, de fonctionner tant à haute pression qu'à pression atmosphérique, de générer un plasma « froid » et de permettre une préparation en continu sur de grandes surfaces.

Le procédé DBD présente cependant l'inconvénient majeur d'un rendement énergétique médiocre : une grande partie de la puissance engendrée est dissipée en pure perte. Le problème est lié en grande partie à l'impédance capacitive du circuit de décharge, qui est d'autant plus élevée que la distance entre les électrodes (et par conséquent la distance entre les électrodes et un substrat placé entre celles-ci) est grande. L'énergie dissipée dans la décharge est donc limitée ce qui réduit l'efficacité de décontamination et d'activation de surface du procédé.

### Résumé de l'invention

Un premier but de l'invention est d'améliorer le rendement et l'efficacité d'un procédé DBD, pour la préparation de surface.

Un autre but de l'invention est que cette amélioration conserve son efficacité quelles que soient les conditions imposées. Celles-ci peuvent varier par exemple : par le type de surfaces à préparer (épaisseur du substrat, nature du substrat...), par la nature de différentes couches organiques ou inorganiques à éliminer, etc.

L'objet de l'invention est un procédé, pour la préparation de surface d'un substrat, qui comprend les opérations suivantes :
- introduire ou faire défiler un substrat dans une chambre de réaction dans laquelle sont placées au moins deux électrodes, au moins une barrière diélectrique étant placée entre ces au moins deux électrodes ;
- engendrer une tension électrique à haute fréquence de valeur telle qu'elle entraîne la génération d'un plasma entre les au moins deux électrodes ;
- mettre en service une inductance ajustable disposée en parallèle avec l'inductance de l'installation engendrant la tension électrique, de façon à réduire le déphasage entre la tension et le courant engendré ;
- introduire dans la chambre de réaction au moins un type de molécules telles qu'au contact du plasma, elles engendrent des espèces actives aptes à réagir avec la surface du substrat ;
- adapter la tension et/ou la fréquence fournies par le circuit générateur et/ou la valeur de l'inductance au début ou en cours de procédé, de façon à obtenir des caractéristiques de réaction optimale.
- maintenir le substrat dans la chambre durant un laps de temps suffisant pour obtenir la préparation de surface souhaitée.

On notera que le procédé de l'invention est défini en termes d' « opérations » plutôt que d' « étapes », c'est à dire que la succession des opérations ne s'effectue pas obligatoirement dans l'ordre où elles sont énoncées ci-dessus.

Un avantage du procédé de l'invention est que l'introduction d'une inductance dans le circuit améliore le facteur de puissance de l'installation, ce qui permet non seulement un accroissement considérable de son rendement, mais permet également au procédé de générer suffisamment d'énergie active pour obtenir une efficacité de préparation de surface élevée.

Suivant un mode de réalisation préféré, on module la tension et/ou la fréquence fournies par le circuit générateur et/ou la valeur de l'inductance de façon à favoriser la production d'harmoniques prolongeant le temps durant lequel la tension reste supérieure à la valeur de maintien de l'arc, ce qui a pour conséquence le prolongation du temps de génération du plasma.

Un avantage de ce mode de réalisation est qu'à puissance consommée égale, l'efficacité du procédé est fortement améliorée.

Suivant un mode de réalisation avantageux, le procédé comprend en outre l'opération suivante : faire varier la position et/ou la configuration de l'électrode de façon à obtenir des caractéristiques de réaction optimales. En effet, ces critères font varier les caractéristiques du circuit électrique et ils ont donc une influence sur la configuration du courant.

Suivant un mode de réalisation avantageux, le procédé comprend en outre l'opération suivante : - amener l'atmosphère régnant dans la chambre à une pression déterminée.

Suivant un mode de réalisation préféré, la chambre est ouverte et comprend une zone d'entrée et une zone de sortie pour le substrat, ce qui permet au procédé de l'invention de s'intégrer dans une opération de préparation de surface en continu.

De façon avantageuse, le substrat est isolant et forme lui-même une barrière diélectrique placée entre les au moins deux électrodes.

De façon avantageuse, le substrat est conducteur et forme lui-même une électrode.

Les molécules sont introduites dans la chambre de réaction de préférence sous forme d'un liquide par spray, de gaz ou d'une poudre.

Un autre objet de l'invention est une installation pour la préparation de surface comprenant une chambre, des moyens de transport et des moyens de support pour introduire ou faire défiler un substrat dans la chambre. Une alimentation électrique à haute tension et à haute fréquence est reliée à au moins deux électrodes disposées de part et d'autre du substrat et au moins une barrière diélectrique est disposée entre les au moins deux électrodes. Des moyens de régulation et de contrôle de l'alimentation électrique sont prévus, de même que des moyens d'introduction dans la chambre de molécules propres à engendrer, au contact du plasma, des espèces actives aptes à réagir avec la surface du substrat. Des moyens d'extraction de gaz résiduels sont également prévus. Dans cette installation, une inductance ajustable est placée en parallèle avec le circuit d'alimentation. Les caractéristiques de cette inductance ajustable sont telles qu'elle permet de moduler le déphasage entre la tension générée entre les électrodes et le courant total fourni par la source haute tension.

Un avantage de cette installation est qu'elle peut être réalisée moyennant l'application d'une série de modifications relativement mineures sur des installations existantes.

Dans cette installation, les moyens de régulation de l'alimentation électrique et les moyens de contrôle de l'inductance sont avantageusement couplés de façon à permettre la génération d'harmoniques prolongeant le maintien de la valeur de la tension entre les électrodes à une valeur supérieure à celle de maintien de la décharge électrique.

Suivant un mode de réalisation avantageux, la chambre est ouverte à ses deux extrémités, ce qui permet d'intégrer le procédé de préparation de surface dans une installation de production en continu. Dans ce cadre, la chambre peut avantageusement être intégrée dans une ligne de production d'acier.

Suivant un mode de réalisation avantageux, l'installation est intégrée dans une ligne de production qui comprend une installation de dépôt, la chambre étant placée en amont et/ou en aval de l'installation de dépôt, les moyens de support et/ou de transport du substrat comprenant au moins un rouleau.

Le plasma peut être, de façon avantageuse, généré dans deux zones distinctes disposées de part et d'autre du substrat, de façon telle que la préparation de surface se fasse sur chacune des faces de ce substrat simultanément.

Un autre objet de l'invention est une inductance de déphasage pour l'installation de l'invention. Cette inductance comprend un bobinage constitué d'un faisceau d'éléments conducteurs isolés les uns par rapport aux autres, enroulé autour d'un mandrin; un noyau magnétique plongeur disposé à l'intérieur de ce mandrin, isolé de ce mandrin, divisé en plusieurs tronçons par des pastilles isolantes; un dispositif de positionnement relié au noyau plongeur; une connexion isolante reliant le noyau plongeur et le dispositif de positionnement ; un système de contrôle apte à agir sur le dispositif de positionnement, de façon à ajuster la position du noyau magnétique plongeur par rapport au mandrin.

### Brève description des figures

D'autres avantages et particularités de l'invention ressortiront de la description détaillée ci-après de modes de réalisation particuliers de l'invention, référence étant faite aux figures, dans lesquelles :
La Fig.1 est une vue schématique en élévation, d'une installation pour la préparation de surface;
La Fig.2 est un schéma électrique équivalent de l'installation de la Fig. 1, avant la formation de plasma;
La Fig.3 est un schéma électrique équivalent de l'installation de la Fig. 1 après la génération de plasma;
La Fig. 4 est un schéma électrique équivalent de l'installation suivant l'invention ;
La Fig. 5 est un oscillogramme tension/courant dans une installation classique
La Fig. 6 est un oscillogramme tension/courant obtenu grâce au procédé de l'invention ;
La Fig.7 est une vue schématique en élévation, d'une variante d'une installation ouverte à ses deux extrémités pour la préparation de surface biface de substrat suivant l'invention;

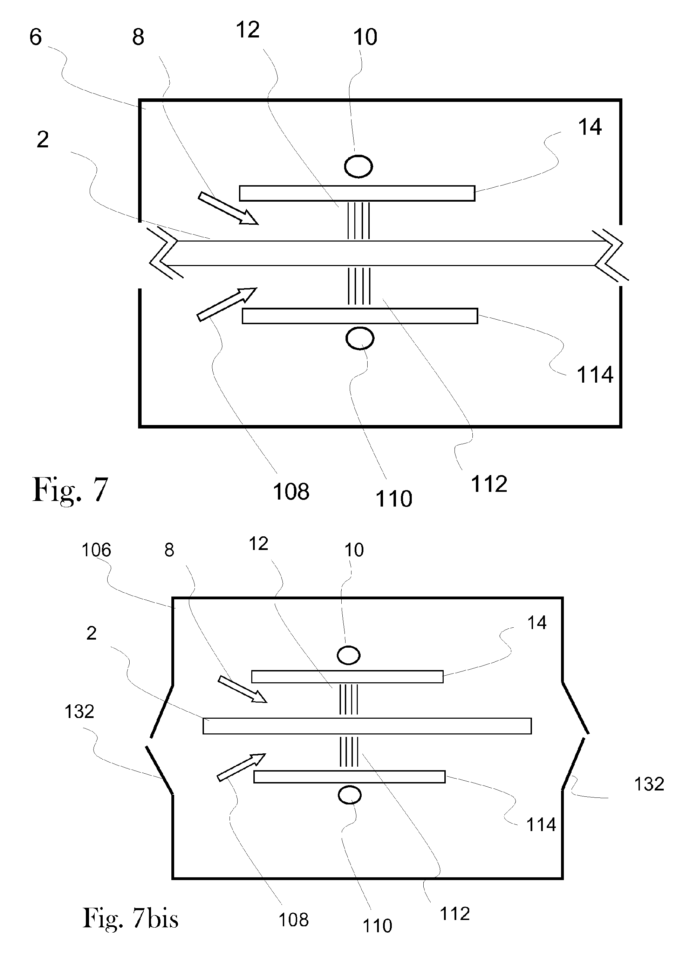

La Fig.7 bis est une vue schématique en élévation, d'une variante d'une installation fermée à ses deux extrémités pour la préparation de surface biface de substrat suivant l'invention;

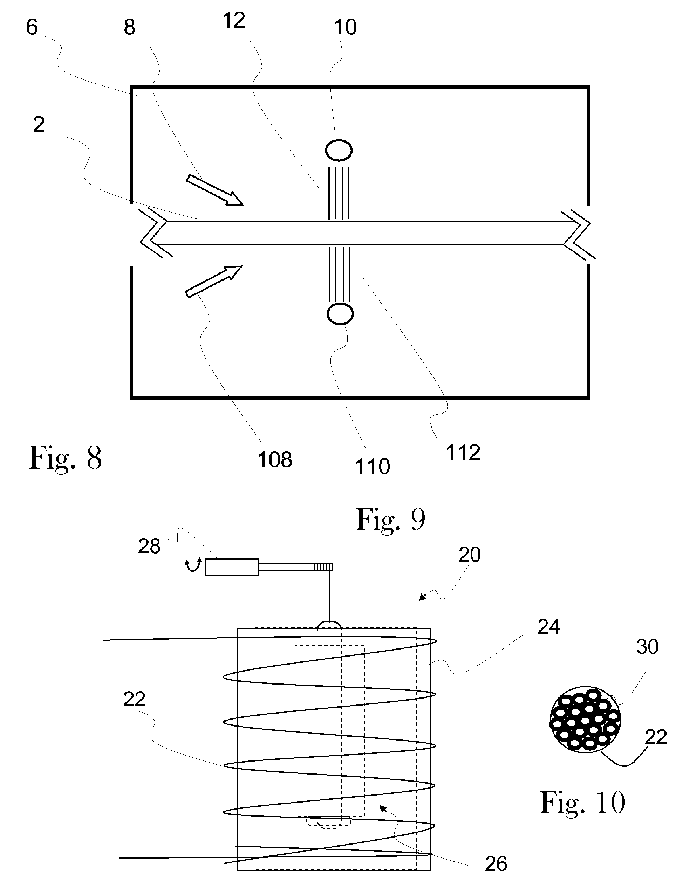

La Fig. 8 est une vue schématique en élévation, d'une variante d'une installation dans le cas d'un substrat isolant.
La Fig. 9 est une vue schématique en élévation d'une bobine de self pour une installation suivant l'invention. La Fig. 10 est une vue en coupe d'un toron du fil de bobinage utilisé dans la self représentée à la Fig.9.
Les figures ne sont pas forcément dessinées à l'échelle. Généralement, des éléments semblables sont dénotés par des références semblables dans les figures, le chiffre des centaines servant à différencier des variantes d'un même élément.

### Description détaillée de modes de réalisation particuliers

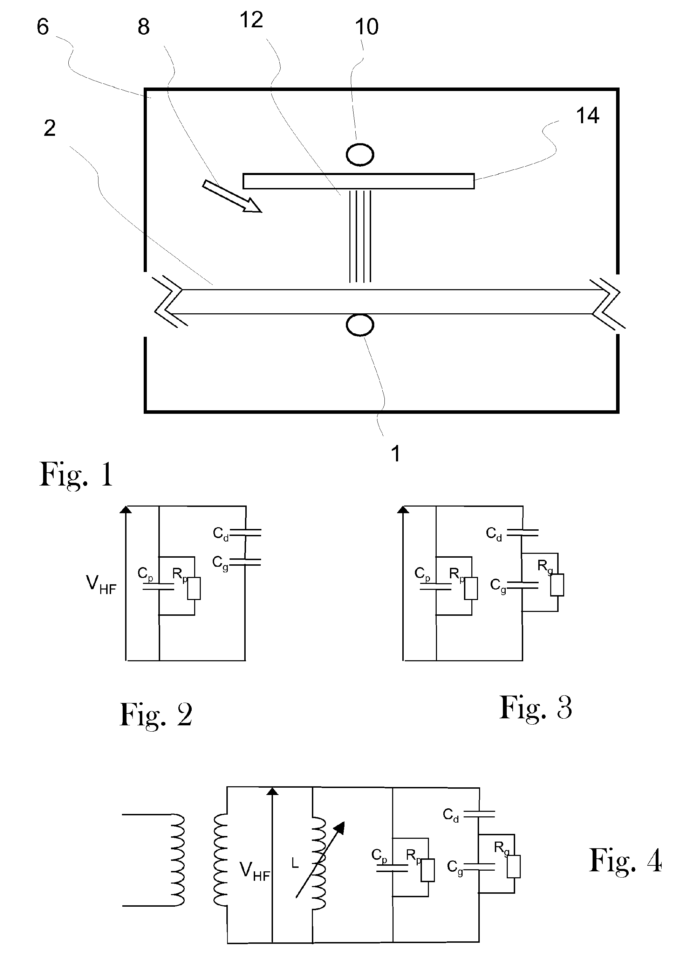

La Fig. 1 est une vue schématique de l'installation suivant l'invention, qui est ici appliquée à une production de verre en continu suivant le procédé « de verre flotté ». En particulier la chambre de traitement est placée dans la galerie de recuisson. Le sens du déplacement correspond au plan de la feuille de dessin. Au cours de son défilement, la feuille de verre 2 pénètre dans une « chambre » 6 ouverte à ses deux extrémités (entrée et sortie). Des molécules 8 destinées à produire des espèces réactives sont introduites dans la chambre 6. On notera que la façon d'introduire ces molécules (à contre courant dans la figure 1), est donnée à titre d'exemple, ce qui n'exclut aucune autre forme d'introduction (perpendiculaire au substrat...). Deux électrodes 1, 10 s'étendant suivant un axe perpendiculaire au sens de défilement de la feuille de verre 2 sont disposées dans la chambre 6. La forme de l'électrode reprise à la figure 1 est donnée à titre d'exemple. Aucune autre géométrie n'est exclue.

Une haute tension à haute fréquence étant appliquée entre ces électrodes 1, 10. On assiste à la génération d'un plasma 12 (représenté schématiquement par une série de lignes parallèles), qui génère des espèces actives issues des molécules 8 introduites dans la chambre 6, rendant possible la préparation de surface. La tension est préférentiellement comprise entre 1,000 et 200,000 V pic à pic, et de façon plus préférentielle entre 5,000 et 100,000 V pic à pic, et de façon encore plus préférentielle entre 10,000 et 40,000 V pic à pic. La fréquence est préférentiellement comprise entre 10 KHz et 1,000 KHz, et de façon plus préférentielle entre 20 KHz et 400 KHz, et de façon encore plus préférentielle entre 50 KHz et 200 KHz.

Afin de réduire le risque éventuel de formation d'arcs électriques directement entre les deux électrodes, une barrière diélectrique 14 peut être disposée dans la chambre entre les emplacements des deux électrodes 1, 10. La chambre 6 étant de type ouvert, il est nécessaire de disposer également de puissants moyens d'extraction, qui éliminent les produits de réaction générés par le procédé. Il va de soit que ce qui a été décrit plus haut dans la galerie de recuisson d'une production en continu de verre s'applique mutatis mutandis notamment à une production en continu d'acier. Tant pour la production de verre que d'acier, l'électrode 1 peut également avantageusement servir de moyen de support et de transport du substrat. Par ailleurs, dans le cas particulier où le substrat est conducteur, comme c'est la cas en métallurgie, il peut assurer lui-même le rôle d'une électrode.

Le problème qui se pose généralement dans ce type de procédé, dès lors que l'on veut le faire passer du stade expérimental à la production industrielle, est la faiblesse du rendement obtenu au regard de l'énergie dépensée pour la génération du plasma. En conséquence, il faut améliorer ce rendement pour rendre le procédé non seulement énergétiquement rentable, mais également permettre au procédé de générer suffisamment d'énergie active pour être efficace. On a donc entamé une étude poussée de tous les facteurs intervenant au niveau énergétique, ce qui a permis de réduire très schématiquement l'installation en cause à deux schémas équivalents tels que représentés aux Fig. 2 et 3.

La Fig. 2 est un schéma équivalent très simplifié de l'installation avant l'amorçage. Une haute tension étant appliquée entre les électrodes 1, 10. L'installation de décharge dans la chambre 6 se résume essentiellement à une addition de capacités en parallèle et en série, à savoir Cp (capacité parasite en parallèle avec une résistance parasite Rp), Cd (capacité du diélectrique et/ou du substrat), et Cg (capacité du gaz).

La Fig. 3 représente le même schéma lorsque le plasma est généré. A ce moment, Cg est shunté par une résistance Rg qui représente la résistance du plasma.

En l'absence de décharge (c'est-à-dire tant que la tension appliquée entre les électrodes est inférieure à la tension d'amorçage, la valeur de Rg est extrêmement élevée et le courant total fourni par la source est pratiquement uniquement capacitif, la partie réactive étant essentiellement fonction de la perte diélectrique dans l'isolant de l'électrode supérieure et/ou inférieure et du substrat. Au cours de la décharge, le courant « utile » Ig passant dans le plasma reste toujours faible au regard de sa composante capacitive. L'exploitation de la source de tension est donc limitée, la puissance fournie étant dissipée dans la production d'un courant réactif très important, alors que seule la composante active, fournissant la puissance wattée à la décharge (Pw=Rg x Ig²), est utile.

On a donc songé, afin de compenser le manque de puissance wattée, à placer, en parallèle de l'installation, une self L jouant le rôle de « réservoir énergétique », qui permet de générer un courant en opposition de phase par rapport à l'énergie absorbée par la charge capacitive, ce qui permet une restitution pratiquement totale de l'énergie mise en jeu. On obtient donc un schéma équivalent tel que représenté à la Fig. 4.

On remarquera toutefois que ce type de compensation n'est pas similaire à la compensation obtenue par exemple en mettant une self en parallèle à une ligne de distribution de courant. En effet, on n'a pas ici affaire à une composante capacitive fixe, comme c'est le cas dans un réseau de distribution, mais à une charge éminemment variable en fonction de la fréquence (on parle ici de Kilohertz), de l'épaisseur du substrat, des réactifs introduits dans la chambre (qui font varier les propriétés électriques et diélectriques du gaz et du plasma, etc.). En conséquence, il est nécessaire de disposer d'un type de self tout à fait particulier, capable non seulement de supporter les conditions de charge engendrées dans une installation de grande puissance, sous haute tension, bien sûr, mais également sous haute fréquence, et présentant également la possibilité d'être ajustée de façon relativement fine en fonction des conditions imposées lors de chaque type de préparation de surface. En effet, la charge résultante variera notamment en fonction des différents paramètres du procédé comme par exemple, la nature des espèces actives engendrées, l'épaisseur du verre, l'écartement entre le substrat et chacune des électrodes (« gap »). Cet écartement est préférentiellement compris entre 0.5 mm et 100 mm, et de façon plus préférentielle entre 1 mm et 20 mm, et de façon encore plus préférentielle entre 3 mm et 6 mm.

Différents essais sur la possibilité de mise en pratique concrète du procédé de l'invention ont mis en lumière une conséquence avantageuse et inattendue de ce procédé.

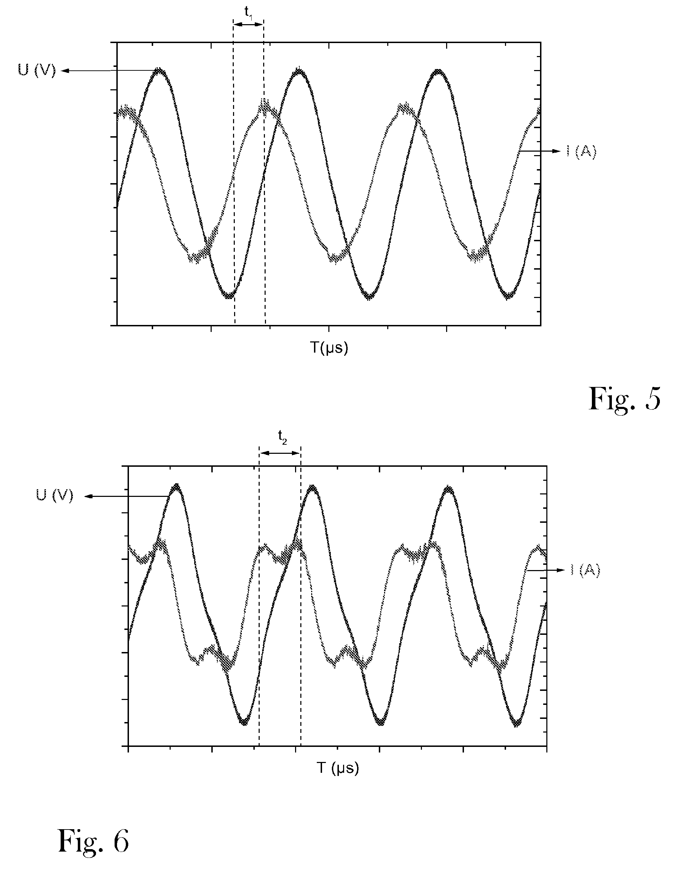

En se référant à la Fig.5, on voit qu'un autre phénomène est responsable en partie du médiocre rendement d'une installation pour la préparation de surface sous plasma DBD : lorsqu'on applique une haute tension HF, pour chaque demi-période, une décharge ne peut être maintenue amorcée que pendant le laps de temps T1 où la tension appliquée est supérieure à une tension d'amorçage V1. Cet intervalle de temps est intimement lié aux paramètres décrits ci-dessus. Ce phénomène se répète évidemment à chaque demi-période. Le rendement du procédé se trouve donc limité par le rapport entre T1 et la longueur d'une demi-période.

Suivant la loi de Fourier, si une source alimente un dipôle non linéaire, le courant résultant ne sera pas linéaire et prendra une forme complexe que l'on peut décomposer en une superposition de plusieurs courbes, soit celles d'une fréquence « fondamentale » et d'une somme d'harmoniques.

En l'occurrence, on a constaté que l'interposition d'une self dans le circuit donne lieu à une déformation de la courbe de passage du courant dans le plasma, comme montré à la Fig.6. Cette courbe peut être décomposée suivant le principe des séries de Fourier en une fondamentale et une série d'harmoniques dont les plus significatives par leur amplitude sont les harmoniques impaires 3 et 5. Comme on peut le remarquer, la courbe de passage du courant présente une sorte de « plateau » durant un intervalle de temps T2, de longueur bien supérieure à l'intervalle T1 observé sur la courbe de la Fig. 5. La longueur de cet intervalle peut être optimisée en jouant sur les caractéristiques du circuit, et notamment sur la fréquence et sur la valeur de l'inductance L. En conséquence, dans l'installation de l'invention, en interposant une self ajustable de caractéristiques adéquates, on obtient, toutes choses étant par ailleurs égales, non seulement une augmentation de la puissance active, mais également un temps de décharge plus long, et en conséquence un rendement énergétique bien meilleur. La puissance active est augmentée de façon préférentielle d'au moins 10% et de façon plus préférentielle d'au moins 25%, et de façon encore plus préférentielle d'au moins 50%. Le temps de décharge est augmenté de façon préférentielle d'au moins 15% et de façon plus préférentielle d'au moins 30%, et de façon encore plus préférentielle d'au moins 60%. On notera par ailleurs que pour déterminer la valeur « optimale » de la self, il faut tenir compte de l'inductance propre du circuit d'alimentation (qui comprend un transformateur), dont la valeur n'est pas forcément négligeable. Le circuit d'alimentation ayant sa propre fréquence de résonance, la valeur de L pourra, dans certaines conditions, être fortement réduite.

Parmi les avantages du procédé tel que décrit, on peut relever les suivants :
- du fait de l'augmentation de l'efficacité de la préparation de surface, on peut réduire la quantité des molécules utilisées, ce qui génère un surcroît d'économies.
- une augmentation de la vitesse de préparation de surface, qui a pour corollaire une diminution du temps du traitement. En conséquence il est possible de traiter en continu des substrats se déplaçant à plus grande vitesse. Inversement, on peut réduire la largeur de la chambre de traitement, d'où un gain de place non négligeable.
- on constate une meilleure décomposition des molécules activées lors des réactions engendrées au sein du plasma et donc une meilleure efficacité de la préparation de surface. En conséquence, on peut préparer des surfaces en évitant de passer par des stades de pré traitement.
- Enfin, il est également possible, comme représenté sur la Figure 7, par un choix judicieux des caractéristiques, de travailler simultanément sur les deux faces du substrat. On a en effet la possibilité, en usant d'artifices divers (séparation physique ou appareillage d'extraction disposé de façon adéquate) d'introduire des molécules différentes 8, 108 de part et d'autre du substrat dans les deux zones de plasma (12, 112). En outre, la distance entre le substrat à préparer et les deux électrodes (10, 110), recouvertes par des diélectriques (14, 114), peut également être ajustée en fonction des critères de préparation souhaitée. Il va de soi que le schéma équivalent d'une telle installation est plus complexe et qu'il n'est possible d'en maîtriser les caractéristiques que grâce à la présence de l'inductance ajustable caractéristique de l'installation de l'invention. De plus, la présence de deux intervalles agissant comme des capacités en série diminue a priori le courant de décharge, d'où l'intérêt de la présente invention.
Il va de soi que ce qui a été décrit plus haut pour une installation de préparation de surface en continu s'applique mutatis mutandis à une installation ouverte portant sur des substrats discontinus, tels que par exemple des volumes de verre prédécoupés. La Fig. 7bis montre une chambre fermée (106) conçue pour une préparation de surface de substrat discontinu. Dans ce cas, un ou deux dispositifs de fermeture (132) permettent soit de travailler à pression atmosphérique soit de travailler à des pressions s'écartant nettement de la pression atmosphérique (typiquement, entre 10⁻¹ Pa et 110 kPa) (dans le cas de l'installation représentée à la Fig. 1, il est nécessaire d'avoir recours à des dispositifs d'extraction puissants pour s'écarter de la pression ambiante). Dans le cas d'un procédé fonctionnant à pression réduite, on peut travailler avec des écartements (gaps) plus importants ou avec des substrats (dans le cas de surface isolante) d'épaisseur plus élevée. Une telle installation de préparation de surface peut par exemple être intégrée dans une ligne de dépôt de couches travaillant à basse pression type sputtering magnétron. La préparation de surface se faisant évidement avant la phase de dépôt.

Les avantages liés à la génération d'un plasma de part et d'autre d'un substrat sont multiples. En effet, le nombre d'applications techniques d'un substrat traité sur les deux faces va toujours croissant.
La Fig. 8 est une variante de l'installation présentée sur la figure 7. Si le substrat est isolant, dans les conditions qui prévalent dans la chambre de préparation, il peut former lui-même une barrière diélectrique, ce qui nous donne la possibilité de ne pas utiliser une barrière diélectrique supplémentaire. Il est ainsi possible de s'affranchir de la présence d'au moins une barrière diélectrique supplémentaire (14, 114).

La Fig. 9 est une représentation simplifiée d'une forme de réalisation de la self de compensation 20 de l'installation de l'invention. Cette self 20 est composée essentiellement d'un bobinage 22 enroulé autour d'un mandrin 24. La tension à ces bornes pouvant être de 60 kV, le choix du matériau utilisé pour le mandrin, support du bobinage, est très important. Avantageusement l'Acculon a été retenu.Un noyau plongeur 26, soigneusement isolé et relié mécaniquement à un dispositif de positionnement 28 géré par un système de contrôle, est disposé à l'intérieur de ce mandrin 24. Vu les conditions d'utilisation particulières auxquelles cette self doit faire face en régime, il a été fait appel à une série d'innovations dans sa réalisation pratique. Ainsi, le bobinage 22 est réalisé avec un faisceau de fils de cuivre 30 (voir Fig.10), isolés, afin d'augmenter la section de passage du courant HF (en prenant en compte l'effet pelliculaire) et également pour réduire l'échauffement. Ainsi, il est possible de diviser le courant HF total par 50 en réalisant un faisceau de conducteur de 50 brins isolés entre eux. Le pas de bobinage est fixé de sorte que le risque d'amorçage entre spire soit aussi réduit que possible. Un bobinage en une seule couche est donc préférable, bien qu'il ait pour conséquence un encombrement important du dispositif dans son ensemble. L'ajustement de la position du noyau magnétique 26, donc de la valeur de la self 20, est télécommandé afin que cette manoeuvre soit rendue possible sans danger pour l'opérateur.

Il apparaîtra évident pour l'homme du métier que la présente invention n'est pas limités aux exemples illustrés et décrits ci-dessus. L'invention comprend chacune des caractéristiques nouvelles ainsi que leur combinaison. La présence de numéros de référence ne peut être considérée comme limitative. L'usage du terme « comprend » ne peut en aucune façon exclure la présence d'autres éléments autres que ceux mentionnés. L'usage de l'article défini « un » pour introduire un élément n'exclut pas la présence d'une pluralité de ces éléments. La présente invention a été décrite en relation avec des modes de réalisations spécifiques, qui ont une valeur purement illustrative et ne doivent pas être considérés comme limitatifs.

## Revendications

1. Un procédé pour la préparation de surface de substrat **caractérisé en ce qu'**il comprend les opérations suivantes :
- introduire ou faire défiler un substrat dans une chambre de réaction (6, 106) dans laquelle sont placées au moins deux électrodes (1, 10, 110), au moins une barrière diélectrique (14, 114) étant placée entre ces au moins deux électrodes (1, 10, 110);
- engendrer une tension électrique à haute fréquence de valeur telle qu'elle entraîne la génération d'un plasma (12, 112) entre les au moins deux électrodes (1, 10, 110);
- mettre en service une inductance ajustable (L) disposée en parallèle avec l'inductance propre de l'installation engendrant la tension électrique, de façon à réduire le déphasage entre la tension et le courant engendré ;
- introduire dans la chambre de réaction (6, 106) au moins un type de molécules (8, 108) telles qu'au contact du plasma, elles engendrent des espèces actives aptes à réagir avec la surface du substrat ;
- adapter la tension et/ou la fréquence fournies par le circuit générateur et/ou la valeur de l'inductance ajustable (L) au début ou en cours de procédé, de façon à obtenir des caractéristiques de réaction optimales ;
- maintenir le substrat (2) dans la chambre durant un laps de temps suffisant pour obtenir sur au moins une de ses faces une préparation de surface souhaitée.

2. Procédé selon la revendication 1, **caractérisé en ce qu'**il comprend en outre l'opération suivante :
- adapter la tension et/ou la fréquence fournies par le circuit générateur et/ou la valeur de l'inductance (L) de façon à favoriser la production d'harmoniques prolongeant le temps durant lequel la tension reste supérieure à la valeur de maintien de la décharge électrique.

3. Procédé selon la revendication 2, **caractérisé en ce que** l'on favorise essentiellement les harmoniques d'ordre 3 et 5

4. Procédé selon l'une quelconque des revendications 1 à 3, **caractérisé en ce qu'**il comprend en outre l'opération suivante : faire varier la position et/ou la configuration de l'au moins une électrode (1, 10, 110) de façon à obtenir des caractéristiques de réaction optimales.

5. Procédé selon l'une quelconque des revendications 1 à 4 **caractérisé en ce qu'**il comprend en outre l'opération suivante : - amener l'atmosphère régnant dans la chambre (6, 106) à une pression déterminée.

6. Procédé selon l'une quelconque des revendications 1 à 5, **caractérisé en ce que** la chambre est ouverte (6) et comprend une zone d'entrée et une zone de sortie pour le substrat.

7. Procédé selon l'une quelconque des revendications 1 à 5, **caractérisé en ce que** la chambre est fermée (106) à ses deux extrémités.

8. Procédé selon l'une quelconque des revendications 1 à 7, **caractérisé en ce que** le substrat (2) est isolant et forme lui-même une barrière diélectrique.

9. Procédé selon l'une quelconque des revendications 1 à 7, **caractérisé en ce que** le substrat (2) est conducteur et forme lui-même une électrode.

10. Procédé selon l'une quelconque des revendications 1 à 9, **caractérisé en ce que** les molécules (8, 108) sont introduites dans la chambre de réaction (6, 106) sous forme d'un gaz.

11. Procédé selon l'une quelconque des revendications 1 à 9, **caractérisé en ce que** les molécules (8, 108) sont introduites dans la chambre de réaction (6, 106) sous forme d'un liquide.

12. Procédé selon l'une quelconque des revendications 1 à 9, **caractérisé en ce que** les molécules (8, 108) sont introduites dans la chambre de réaction (6, 106) sous forme d'une poudre.

13. Une installation pour la préparation de surface de substrats (2) comprenant une chambre (6, 106), des moyens de transport et des moyens de support du substrat dans la chambre, une alimentation électrique à haute tension et à haute fréquence reliée à au moins deux électrodes (1, 10, 110) disposées de part et d'autre du substrat (2), au moins une barrière diélectrique (14, 114) disposée entre les au moins deux électrodes(1, 10, 110), des moyens de régulation et de contrôle de l'alimentation électrique, des moyens d'introduction dans la chambre (6, 106) de molécules (8, 108) propres à engendrer, au contact du plasma, des espèces actives aptes à réagir avec la surface du substrat, des moyens d'extraction de substances résiduelles, **caractérisée en ce qu'**une inductance ajustable (L) est placée en parallèle avec l'inductance du circuit d'alimentation, les caractéristiques de cette inductance ajustable (L) étant telles qu'elle permet de moduler le déphasage entre la tension générée entre les électrodes (1, 10, 110) et le courant total fourni par la source haute tension.

14. Une installation pour la préparation de surface suivant la revendication 13 **caractérisée en ce que** les moyens de régulation de l'alimentation électrique et les moyens de contrôle de l'inductance (L) sont couplés de façon à permettre la génération d'harmoniques prolongeant le maintien de la valeur de la tension entre les électrodes (1, 10, 110) à une valeur supérieure à celle de maintien de la décharge électrique.

15. Une installation pour la préparation de surface suivant l'une quelconque des revendications 13 ou 14 **caractérisée en ce que** la chambre (6) est ouverte à ses deux extrémités.

16. Une installation pour la préparation de surface suivant l'une quelconque des revendications 13 ou 14 **caractérisée en ce que** la chambre (106) est fermée à ses deux extrémités.

17. Une installation de dépôt suivant l'une quelconque des revendications 13 à 15 **caractérisée en ce que** la chambre (6) est intégrée dans une ligne de production de substrat en continu et/ou en discontinu.

18. Une installation pour la préparation de surface suivant l'une quelconque des revendications 13 à 14 et 16 **caractérisée en ce que** la chambre (106) est intégrée dans une ligne de production de substrat en discontinu.

19. Une installation de dépôt suivant l'une quelconque des revendications 13 à 18 **caractérisée en ce que** les moyens de support et/ou de transport constituent une des électrodes (1).

20. Installation de dépôt suivant l'une quelconque des revendications 13 à 14 et 16 **caractérisée en ce qu'**elle est intégrée dans une ligne de dépôt travaillant à basse pression.

21. Une installation pour la préparation de surface suivant l'une quelconque des revendications 13 à 18 et 20 **caractérisée en ce que** le plasma est généré dans deux zones distinctes disposées de part et d'autre du substrat, de façon telle que la préparation de surface se fasse sur chacune des faces de ce substrat simultanément.

22. Une installation pour la préparation de surface suivant l'une quelconque des revendications 13 à 21 **caractérisée en ce que** l'inductance comprend :
- un bobinage (22) constitué d'un faisceau d'éléments conducteurs (30) isolés les uns par rapport aux autres, enroulé autour d'un mandrin (24) ;
- un noyau magnétique plongeur (26) disposé à l'intérieur de ce mandrin (24), isolé de ce mandrin (24);
- un dispositif de positionnement (28) relié au noyau plongeur (26) ;
- une connexion isolante reliant le noyau plongeur (26) et le dispositif de positionnement ;
- un système de contrôle apte à agir sur le dispositif de positionnement, de façon à ajuster la position du noyau magnétique plongeur (26) par rapport au mandrin (24).
